# EUROPÄISCHE PATENTANMELDUNG

(11) **EP 0 849 787 A1**
(43) Veröffentlichungstag der Anmeldung: **24.06.1998**
(21) Anmeldenummer: 97120362.5
(22) Anmeldetag: 20.11.1997
(51) Int. Cl.: H01L 21/762

(54) **Verfahren zur Herstellung einer intergrierten Schaltungsanordnung**

(30) Priorität: 18.12.1996 DE 19652853
(71) Anmelder: SIEMENS AKTIENGESELLSCHAFT, 80333 München (DE)
(72) Erfinder: Schwalke, Udo, Dr., 84431 Heldenstein (DE)

(57) **Zusammenfassung**

In einem Substrat (11) werden Gräben (13, 14) gebildet, die aktive Gebiete (15) definieren. Eine erste isolierende Schicht (16), die die engen Gräben (13) auffüllt, wird konform abgeschieden und mittels einer Maske und anisotropem Ätzen so strukturiert, daß an den Flanken der weiten Gräben (14) Spacer (162) und im Bereich der weiten Gräben Stützstellen (161) entstehen. Durch Bildung einer zweiten isolierenden Schicht (120) mit im wesentlichen planarer Oberfläche und einem planarisierenden Schichtabtrag durch chemisch-mechanisches Polieren oder konventionelles Trockenätzen wird die Oberfläche der aktiven Gebiete (15) freigelegt.

## Beschreibung

Bei der Herstellung von integrierten Schaltungsanordnungen in Halbleitersubstraten werden Isolationsstrukturen gebildet, die benachbarte aktive Gebiete im Halbleitersubstrat gegeneinander isolieren. In hochintegrierten Schaltungen werden zunehmend sogenannte Shallow-Trench-Isolationen verwendet. Dabei handelt es sich um Gräben, die mit isolierendem Material, meist Oxid, gefüllt werden. Es wird eine Planarisierung durchgeführt, bei der die Oberfläche der aktiven Gebiete freigelegt wird und die Oberflächen der Oxidfüllungen in etwa die gleiche Höhe wie die Oberfläche der aktiven Gebiete erhalten. Die Planarisierung bei der Herstellung von Shallow-Trench-Isolationen erfolgt meist durch chemisch-mechanisches Polieren.

Da in integrierten Schaltungen die Breite der Isolationsstrukturen über die gesamte integrierte Schaltung in der Regel nicht konstant ist, werden bei der Shallow-Trench-Isolation isolierende Gräben unterschiedlicher Weite gebildet. Darüber hinaus schwankt die Dichte von aktiven Gebieten und isolierenden Gräben stark. Das führt bei der Planarisierung zu Schwierigkeiten, so daß die sich ergebende Oberfläche auch nach der Planarisierung Stufen aufweist, die vielfach als Topologiestufen bezeichnet werden.

Es ist vorgeschlagen worden, zur Vermeidung von Topologiestufen bei der Planarisierung durch chemisch-mechanisches Polieren eine zusätzliche Lackplanarisierungsmaske zu verwenden (siehe B. Davari et al, IEDM Tech. Digest, p. 61 (1989)). Dabei werden nach Abscheidung einer isolierenden Schicht, die zur Füllung der Gräben verwendet wird, in weiten Gräben Stützstellen aus Lack gebildet. Anschließend wird ganzflächig eine weitere Lackschicht aufgebracht, die durch Verfließen eine im wesentlichen planare Oberfläche aufweist. Ausgehend von dieser planaren Oberfläche wird durch chemisch-mechanisches Polieren die Planarisierung durchgeführt, bis die Oberfläche der aktiven Gebiete freigelegt ist. Die Stützstellen aus Lack und die weitere Lackschicht werden dabei entfernt. Damit die Stützstellen aus Lack beim Aufbringen des weiteren Lackes nicht angegriffen werden, müssen die Stützstellen aus Lack getempert werden. Diese Temperung erfolgt bei Temperaturen um 180 °C und führt teilweise zu einer Veränderung der Form der Lackstützstellen durch Verfließen. Dadurch wird die Planarisierung verschlechtert.

Zur Planarisierung von Mehrlagenmetallverdrahtungen ist in Y. Matsubara et al., IEDM Tech. Digest, p. 665 (1993) ein weiteres Verfahren zur Planarisierung vorgeschlagen worden, bei dem auf einer isolierenden Schicht, die eine Metallisierungsebene bedeckt, streifenförmige Stützstrukturen aus Photolack gebildet werden. Durch gezielte Belichtung in Bereichen, in denen die Metallisierungsebene wenig Leitungen aufweist, werden die streifenförmigen Stützstrukturen hauptsächlich in diesen Bereichen gebildet. Oberhalb der Stützstrukturen wird ganzflächig eine zweite Lackschicht aufgebracht und planarisiert.

Der Erfindung liegt das Problem zugrunde, ein Verfahren zur Herstellung einer integrierten Schaltungsanordnung anzugeben, das zur Herstellung von Shallow-Trench-Isolationen geeignet ist und mit dem eine verbesserte Planarisierung auch über globale Topologiestufen erzielt wird.

Dieses Problem wird erfindungsgemäß gelöst durch ein Verfahren nach Anspruch 1. Weitere Ausgestaltungen der Erfindung gehen aus den Unteransprüchen hervor.

In einer Hauptfläche eines Halbleitersubstrats, vorzugsweise einer monokristallinen Siliziumscheibe oder der monokristallinen Siliziumschicht eines SOI-Substrats, werden erste isolierende Gräben und zweite isolierende Gräben geätzt. Die ersten isolierenden Gräben und die zweiten isolierenden Gräben definieren aktive Gebiete.

Die ersten isolierenden Gräben weisen eine geringere Weite auf als die zweiten isolierenden Gräben. Dabei können die Weiten verschiedener erster isolierender Gräben sowie verschiedener zweiter isolierender Gräben untereinander unterschiedlich sein.

Es wird eine erste isolierende Schicht mit im wesentlichen konformer Kantenbedeckung gebildet, deren Dicke so bemessen wird, daß sie die ersten isolierenden Gräben im wesentlichen auffüllt.

Anschließend wird eine Maske gebildet, die oberhalb der ersten isolierenden Gräben und oberhalb der aktiven Gebiete Öffnungen aufweist, wobei die oberhalb der aktiven Gebiete angeordneten Öffnungen die aktiven Gebiete seitlich überlappen. Anschließend wird die erste isolierende Schicht unter Verwendung der Maske als Ätzmaske durch anisotropes Ätzen strukturiert. Dabei werden oberhalb der zweiten isolierenden Gräben Stützstrukturen gebildet. An den Flanken der zweiten isolierenden Gräben werden Spacer gebildet. Nach Entfernen der Maske wird eine zweite isolierende Schicht mit im wesentlichen planarer Oberfläche gebildet. Anschließend wird durch einen planarisierenden Schichtabtrag die Hauptfläche im Bereich der aktiven Gebiete freigelegt.

In diesem Verfahren werden Stützstrukturen, die zur Vermeidung globaler Topologiestufen im Bereich der zweiten isolierenden Gräben gebildet werden, aus dem Material der ersten isolierenden Schicht gebildet. Diese Stützstrukturen sowie die gleichzeitig an den Flanken der zweiten Gräben gebildeten Spacer verbleiben als Isolationsmaterial auch nach dem planarisierenden Schichtabtrag in den zweiten isolierenden Gräben. Da die Stützstrukturen und die Spacer die zweiten isolierenden Gräben nur teilweise auffüllen, verbleiben nach Entfernen der Maske in der Oberfläche der Struktur im Bereich der zweiten isolierenden Gräben Unebenheiten, deren Breite jedoch durch den Überlapp der Öffnungen der Maske über die aktiven Gebiete vorgegeben ist. Diese Unebenheiten weisen daher über das gesamte Substrat im wesentlichen dieselbe Weite auf, so daß sie bei der Bildung der zweiten isolierenden Schicht ohne weitere Stufen aufgefüllt werden können.

Vorzugsweise überlappen die Öffnungen der Maske die aktiven Gebiete seitlich um einen Abstand, der mindestens so groß ist wie die Dicke der ersten isolierenden Schicht. Dadurch wird sichergestellt, daß an den Flanken der zweiten isolierenden Gräben Spacer entstehen und davon getrennt die Stützstrukturen.

Der planarisierende Schichtabtrag, bei dem die Hauptfläche im Bereich der aktiven Gebiete freigelegt wird, kann sowohl durch chemisch-mechanisches Polieren als auch durch konventionelles anisotropes Trockenätzen erfolgen. Im Hinblick auf eine Prozeßvereinfachung ist es vorteilhaft, den planarisierenden Schichtabtrag durch anisotropes Trockenätzen durchzuführen.

Die erste isolierende Schicht wird vorzugsweise in einem TEOS-Verfahren aus SiO₂ gebildet. Alternativ kann die erste isolierende Schicht aus allen isolierenden Materialien gebildet werden, die einerseits konform abgeschieden werden können und die andererseits bezüglich ihrer Dielektrizitätskonstante, ihrer Temperaturbeständigkeit vorzugsweise über 500 °C und ihrer mechanischen Eigenschaften als Füllung für isolierende Gräben geeignet sind.

Es liegt im Rahmen der Erfindung, auf der Hauptfläche des Halbleitersubstrats vor der Ätzung der ersten isolierenden Gräben und der zweiten isolierenden Gräben ein Gatedielektrikum und eine erste Elektrodenschicht zu bilden. Das Gatedielektrikum und die erste Elektrodenschicht werden dann bei der Ätzung der ersten isolierenden Gräben und der zweiten isolierenden Gräben strukturiert. Bei dem planarisierenden Schichtabtrag wird die Oberfläche der strukturierten ersten Elektrodenschicht freigelegt. Anschließend wird aus der strukturierten ersten Elektrodenschicht eine Gateelektrode gebildet und seitlich davon Source/Drain-Gebiete.

Diese Ausführungsform der Erfindung hat den Vorteil, daß die bezüglich der Reinheitserfordernisse kritischen Prozeßschritte der Bildung eines Gatedielektrikums und einer Elektrodenschicht für eine Gateelektrode bei der Herstellung eines MOS-Transistors vor der Bildung der ersten isolierenden Gräben und zweiten isolierenden Gräben und deren Füllung unter Verwendung von Planarisierungsschritten erfolgt. Da die aktiven Gebiete, die in diesem Fall auch das strukturierte Gatedielektrikum und die strukturierte erste Elektrodenschicht umfassen, nach der Strukturierung der ersten isolierenden Schicht vom Material der ersten isolierenden Schicht umgeben sind, können für die zweite isolierende Schicht, die im weiteren teilweise zur Auffüllung der zweiten isolierenden Gräben beiträgt, Materialien verwendet werden, die wegen ihrer Reinheit in einer Prozeßumgebung, in der Gatedielektrikum und Gateelektrode gebildet werden, nicht zulässig sind. Insbesondere liegt es im Rahmen der Erfindung, die zweite isolierende Schicht aus einem verfließbaren Oxid, zum Beispiel BPSG oder ähnliches, zu bilden.

Es liegt ferner im Rahmen der Erfindung, nach der planarisierenden Strukturierung eine zweite Elektrodenschicht zu bilden. Die zweite Elektrodenschicht und die erste Elektrodenschicht werden unter Verwendung einer gemeinsamen Maske strukturiert, wobei aus der ersten Elektrodenschicht Gateelektroden und aus der zweiten Elektrodenschicht eine Leitungsebene, die Gateleitungen zwischen Gateelektroden umfaßt, gebildet wird. Dabei liegt es im Rahmen der Erfindung, zur Herstellung von n-Kanal-MOS-Transistoren und p-Kanal-MOS-Transistoren mit unterschiedlich dotierten Gateelektroden, die strukturierte erste Elektrodenschicht vor der Bildung der zweiten Elektrodenschicht unterschiedlich zu dotieren. Auf diese Weise wird eine Dotierstoffdiffusion zwischen unterschiedlich dotierten Gebieten der ersten Elekktrodenschicht vermieden.

Im folgenden wird die Erfindung anhand von Ausführungsbeispielen, die in den Figuren dargestellt sind, naher erläutert.
- Figur 1: zeigt einen Schnitt durch ein Halbleitersubstrat nach Ätzung erster isolierender Gräben und zweiter isolierender Gräben unterschiedlicher Weite.
- Figur 2: zeigt den Schnitt durch das Halbleitersubstrat nach Bildung einer ersten isolierenden Schicht mit konformer Kantenbedeckung und einer Maske.
- Figur 3: zeigt den Schnitt durch das Halbleitersubstrat nach Strukturierung der ersten isolierenden Schicht zur Bildung von Stützstrukturen und Spacern und Entfernung der Maske.
- Figur 4: zeigt das Halbleitersubstrat nach Bildung einer zweiten isolierenden Schicht mit planarer Oberfläche.
- Figur 5: zeigt den Schnitt durch das Halbleitersubstrat nach einem planarisierenden Schichtabtrag, bei dem die Hauptfläche im Bereich der aktiven Gebiete freigelegt wurde.
- Figur 6: zeigt einen Schnitt durch ein Halbleitersubstrat mit einer Schichtenfolge, die ein Gatedielektrikum und eine erste Elektrodenschicht umfaßt.
- Figur 7: zeigt einen Schnitt durch das Halbleitersubstrat nach Bildung erster isolierender Gräben und zweiter isolierender Gräben.
- Figur 8: zeigt den Schnitt durch das Halbleitersubstrat nach Bildung einer ersten isolierenden Schicht mit konformer Kantenbedeckung und Bildung einer Maske.
- Figur 9: zeigt den Schnitt durch das Halbleitersubstrat nach Strukturierung der ersten isolierenden Schicht zur Bildung von Stützstrukturen und Spacern.
- Figur 10: zeigt den Schnitt durch das Halbleitersubstrat nach Bildung einer zweiten isolierenden Schicht mit planarer Oberfläche, die eine planarisierende SiO₂-Schicht und eine planarisierende Photolackschicht umfaßt.
- Figur 11: zeigt einen Schnitt durch das Halbleitersubstrat nach einem planarisierenden Schichtabtrag, bei dem die Oberfläche der ersten Elektrodenschicht freigelegt wurde.
- Figur 12: zeigt einen Schnitt durch das Halbleitersubstrat nach Bildung einer zweiten Elektrodenschicht.
- Figur 13: zeigt eine Aufsicht auf das Halbleitersubstrat nach Strukturierung der zweiten Elektrodenschicht und der strukturierten ersten Elektrodenschicht und nach Bildung von Source/Drain-Gebieten.

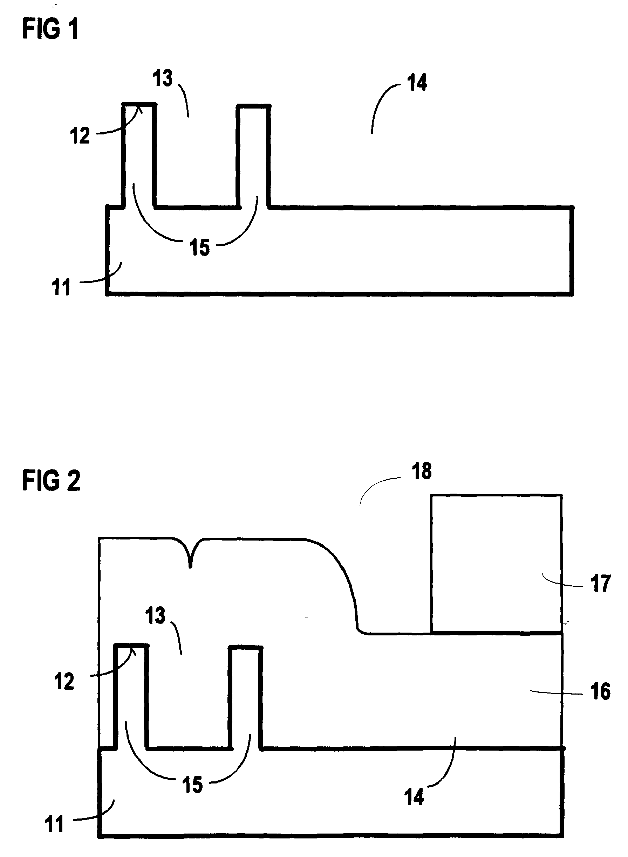

In einer Hauptfläche 12 eines Substrats 11 werden erste isolierende Gräben 13 und zweite isolierende Gräben 14 geätzt (siehe Figur 1). Das Substrat 11 ist zum Beispiel eine monokristalline Siliziumscheibe oder die monokristalline Siliziumschicht eines SOI-Substrats. Die ersten isolierenden Gräben 13 und die zweiten isolierenden Gräben 14 werden unter Verwendung einer Grabenmaske (nicht dargestellt) in einem anisotropen Trockenätzprozeß zum Beispiel mit CL₂/HBr Chemie gebildet. Die ersten Gräben 13 weisen eine Weite von zum Beispiel 0,5 µm, die zweiten Gräben 14 weisen eine Weite von zum Beispiel 40 µm auf. Die ersten Gräben 13 und die zweiten Gräben 14 weisen eine Tiefe von zum Beispiel 400 nm auf. Die ersten Isolationsgräben 13 und die zweiten isolierenden Gräben 14 definieren aktive Gebiete 15, in denen später Bauelemente hergestellt werden.

Anschließend wird ganzflächig eine erste isolierende Schicht mit konformer Kantenbedeckung abgeschieden (siehe Figur 2). Die erste isolierende Schicht 16 wird zum Beispiel in einem TEOS-Verfahren aus SiO₂ in einer Schichtdicke von zum Beispiel 450 nm abgeschieden. Die erste isolierende Schicht 16 füllt die ersten isolierenden Gräben 13 auf. Im Bereich der zweiten isolierenden Graben 14 weist die erste isolierende Schicht 16 dagegen eine deutliche Stufe auf.

Auf der Oberfläche der ersten isolierenden Schicht 16 wird eine Maske 17 mit Hilfe photolithographischer Prozeßschritte zum Beispiel aus Photolack gebildet. Die Maske 17 weist Öffnungen 18 auf, die oberhalb der ersten isolierenden Graben 13 und der aktiven Gebiete 15 angeordnet sind. Einander benachbarte Öffnungen 18 fallen dabei zusammen. Oberhalb der aktiven Gebiete 15 angeordnete Öffnungen 18 überragen dabei das aktive Gebiet 15 seitlich, so daß dadurch die Öffnungen 18 auch teilweise oberhalb der zweiten isolierenden Gräben 14 angeordnet sind. Der Betrag, um den die Öffnungen 18 die aktiven Gebiete 15 seitlich überragen ist vorzugsweise mindestens so groß wie die Dicke der ersten isolierenden Schicht 16 (in Figur 2 ist nur eine Öffnung 18 dargestellt, die oberhalb der beiden aktiven Gebiete 15 und des ersten isolierenden Grabens 13 angeordnet ist).

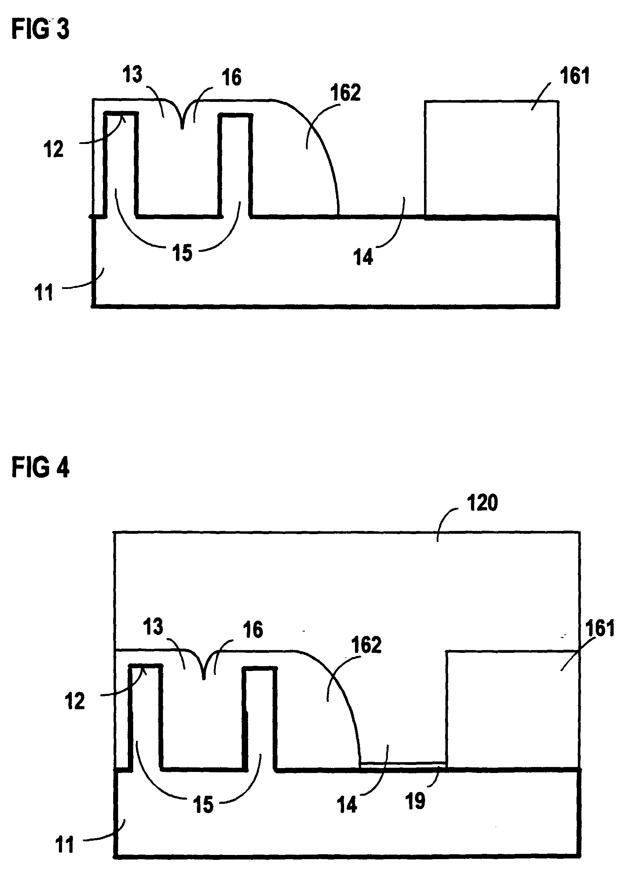

Unter Verwendung der Maske 17 als Ätzmaske wird in einem anisotropen Trockenätzprozeß die erste isolierende Schicht 16 selektiv zur Maske 17 und zum Substrat 11 geätzt. Dabei entstehen im Bereich der zweiten isolierenden Gräben 14 Stützstrukturen 161 und an den Flanken der zweiten isolierenden Gräben 14 Spacer 162 aus der ersten isolierenden Schicht 16 (siehe Figur 3). Die ersten isolierenden Gräben 13 bleiben mit der ersten isolierenden Schicht 16 gefüllt.

Anschließend wird die Maske 17 zum Beispiel naßchemisch mit einem organischen Lösungsmittel entfernt.

Anschließend wird eine thermische Oxidation durchgeführt, bei der freiliegendes Silizium, zum Beispiel die freiliegende Oberfläche des Substrats 11 im Bereich der zweiten isolierenden Gräben außerhalb der Stützstrukturen 161 und der Spacer 162, eine SiO₂-Struktur 19 gebildet.

Es wird eine zweite isolierende Schicht 120 gebildet, die eine planare Oberfläche aufweist (siehe Figur 4). Die zweite isolierende Schicht 120 wird zum Beispiel aus SiO₂ gebildet, das in einem Temperprozeß fließfähig ist. Insbesondere sind Silikatgläser, zum Beispiel Borphosphorsilikatglas, Phosphorsilikatglas, Borsilikatglas oder fließfähige Oxide, wie sie unter dem Namen FOX™ von der Firma Dow Corning angeboten werden, geeignet. Die zweite isolierende Schicht 120 wird in einer Dicke von zum Beispiel 500nm abgeschieden und anschließend einem Temperprozeß bei etwa 950 °C unterzogen. Dabei verfließt die zweite isolierende Schicht 120 so, daß sich eine ebene Oberfläche bildet.

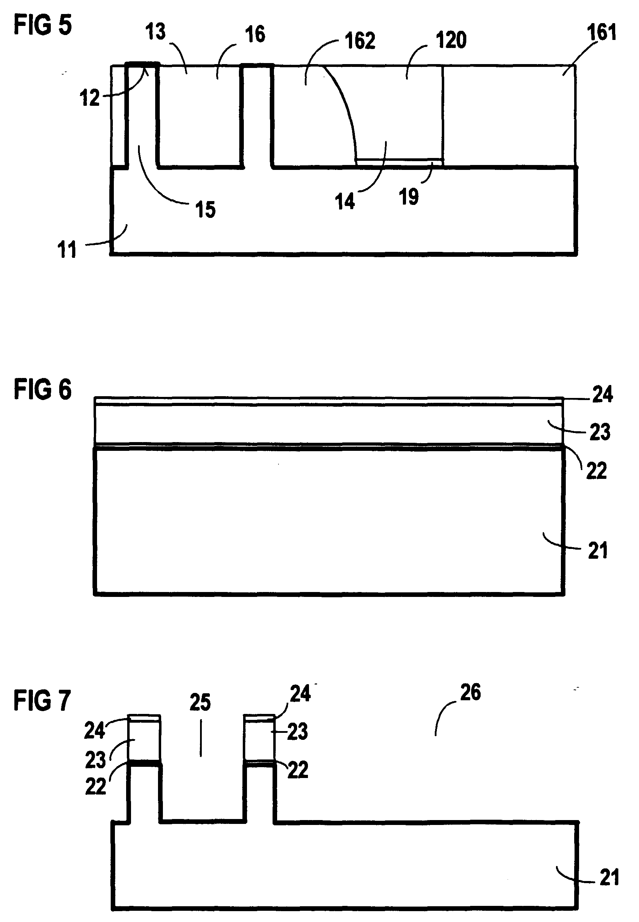

Anschließend wird ein anisotroper Trockenätzprozeß durchgeführt, der SiO₂ selektiv zu Silizium ätzt. Mit Hilfe dieses anisotropen Trockenätzprozesses erfolgt ein planarisierender Schichtabtrag. Die Trockenätzung wird fortgesetzt, bis die Hauptfläche 12 im Bereich der aktiven Gebiete 15 freigelegt ist (siehe Figur 5). Da die Oberfläche der zweiten isolierenden Schicht 120 eben war, ergibt sich nach dem anisotropen Trockenätzprozeß eine Struktur mit ebener Oberfläche. Die ersten isolierenden Gräben 13 und die zweiten isolierenden Gräben 14 sind mit isolierendem Material aufgefüllt.

Der planarisierende Ätzabtrag kann alternativ auch durch chemisch-mechanisches Polieren oder CMP in Kombination mit Trockenätzprozeß bis zur Hauptfläche 12 durchgeführt werden.

Anschließend wird der Prozeß zur Herstellung von Bauelementen im Bereich der aktiven Gebiete 15 fortgesetzt.

Auf ein Halbleitersubstrat 21 wird ein Gatedielektrikum 22, eine erste Elektrodenschicht 23 und eine Deckschicht 24 aufgebracht (siehe Figur 6). Das Substrat 21 umfaßt monokristallines Silizium. Es handelt sich zum Beispiel um eine monokristalline Siliziumscheibe oder um die monokristalline Siliziumschicht eines SOI-Substrates. Das Gatedielektrikum 22 wird zum Beispiel durch thermische Oxidation aus SiO₂ in einer Schichtdicke von zum Beispiel 6 nm gebildet. Die erste Elektrodenschicht 23 wird zum Beispiel aus dotiertem Polysilizium in einer Schichtdicke von 200 nm gebildet. Die Deckschicht 24 wird zum Beispiel aus Si₃N₄ oder SiO₂ in einer Schichtdicke von gebildet.

Die Deckschicht 24 wird unter Verwendung photolithographischer Prozeßschritte und eines Trockenätzprozesses strukturiert. Anschließend werden in einem anisotropen Trockenätzprozeß, zum Beispiel mit Cl₂/HBr erste isolierende Gräben 25 und zweite isolierende Gräben 26 geätzt, die bis in das Substrat 21 hineinreichen (siehe Figur 7). Dabei schützt die Deckschicht 24 die Oberflächen der ersten Elektrodenschicht 23. Die ersten isolierenden Gräben 25 weisen eine geringere Weite auf als die zweiten isolierenden Gräben 26. Die ersten isolierenden Gräben 25 und die zweiten isolierenden Gräben 26 definieren aktive Gebiete 27, in denen nachfolgend Bauelemente hergestellt werden. Die ersten Gräben 25 weisen eine Weite von zum Beispiel 0,5 µm, die zweiten Gräben 26 weisen eine Weite von zum Beispiel 40 µm auf. Die ersten Gräben 25 und die zweiten Gräben 26 weisen eine Tiefe von zum Beispiel 400 nm, bezogen auf die Oberkante der ersten Elektrodenschicht 23, auf. Zur Verbesserung der geätzten Si-Flächen (Etch-Damage) und zur Ausbildung eines Vogelschnabels an der Trenchoberkante kann eine thermische Oxidation durchgeführt werden.

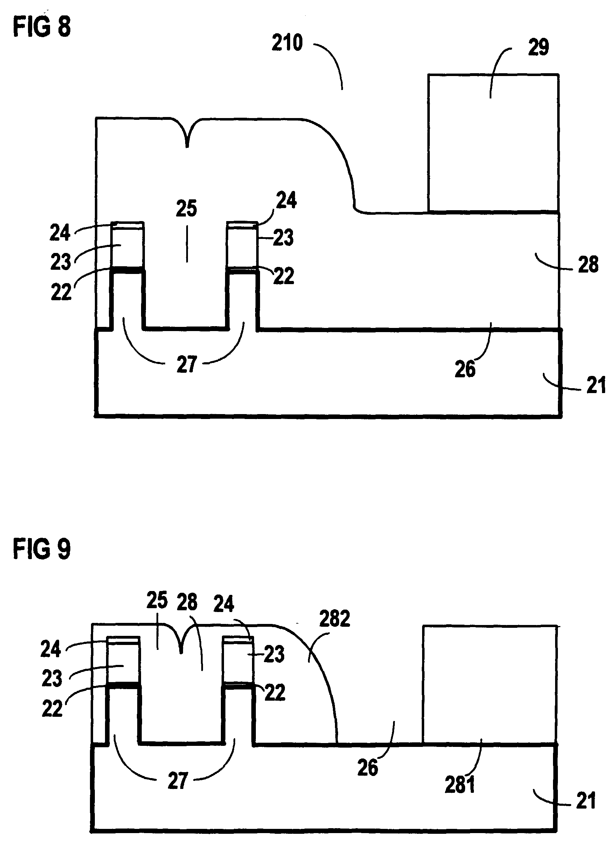

Anschließend wird ganzflächig eine erste isolierende Schicht 28 mit konformer Kantenbedeckung abgeschieden. Die erste isolierende Schicht 28 wird zum Beispiel in einem TEOS-Verfahren in einer Schichtdicke von 500 nm gebildet (siehe Figur 8). Da die ersten isolierenden Gräben 25 eine Weite von 0,5µm, und die zweiten isolierenden Gräben 26 eine Weite von 40 µm aufweisen, werden die ersten isolierenden Gräben 25 von der ersten isolierenden Schicht 28 aufgefüllt. Im Bereich der zweiten isolierenden Gräben 26 bildet sich dagegen eine Stufe, deren Tiefe in etwa der Dicke der ersten isolierenden Schicht 28 entspricht.

An der Oberfläche der ersten isolierenden Schicht 28 wird mit Hilfe photolithographischer Prozeßschritte eine Maske 29 gebildet. Die Maske 29 weist Öffnungen 210 auf, die oberhalb der ersten isolierenden Gräben 25 und der aktiven Gebiete 27 angeordnet sind. Dabei fallen benachbarte Öffnungen 210 zusammen. Die Öffnungen 210, die oberhalb der aktiven Gebiete 27 angeordnet sind, überragen die aktiven Gebiete 27 seitlich.

Ist dem aktiven Gebiet ein erster isolierender Graben 27 benachbart, so fallt die oberhalb des aktiven Gebietes 27 angeordnete Öffnung 210 mit der oberhalb des ersten isolierenden Grabens 25 angeordneten Öffnung 210 zusammen. Ist das aktive Gebiet 27 dagegen einem zweiten isolierenden Graben 26 benachbart, so ragt die Öffnung 210 in den Bereich des zweiten isolierenden Grabens 26 hinein. Der Betrag, um den die Öffnung 210 das aktive Gebiet 27 in Richtung des zweiten isolierenden Grabens 26, der dem aktiven Gebiet 27 benachbart ist, überlappt, richtet sich nach verschiedenen Prozeßparametern, zum Beispiel der verwendeten Lithographie, der Justiergenauigkeit, der Tiefe der isolierenden Gräben 25, 26, etc.. Vorzugsweise wird dieser Betrag mindestens so groß wie die Schichtdicke der ersten isolierenden Schicht 28 gewählt.

Durch anisotropes Trockenätzen selektiv zur Maske 29 und zum Substrat 21 wird anschließend die erste isolierende Schicht 28 strukturiert. Dabei werden innerhalb der zweiten isolierenden Gräben 26 Stützstrukturen 281 und an den Flanken der zweiten isolierenden Gräben 26 Spacer 282 gebildet (siehe Figur 9). Die ersten isolierenden Gräben 25 bleiben mit der ersten isolierenden Schicht 28 gefüllt. Die Ätzung wird unterbrochen, sobald die Oberfläche des Substrats 21 im Bereich der zweiten isolierenden Gräben 26 freigelegt ist. Anschließend wird die Maske 29 zum Beispiel naßchemisch entfernt.

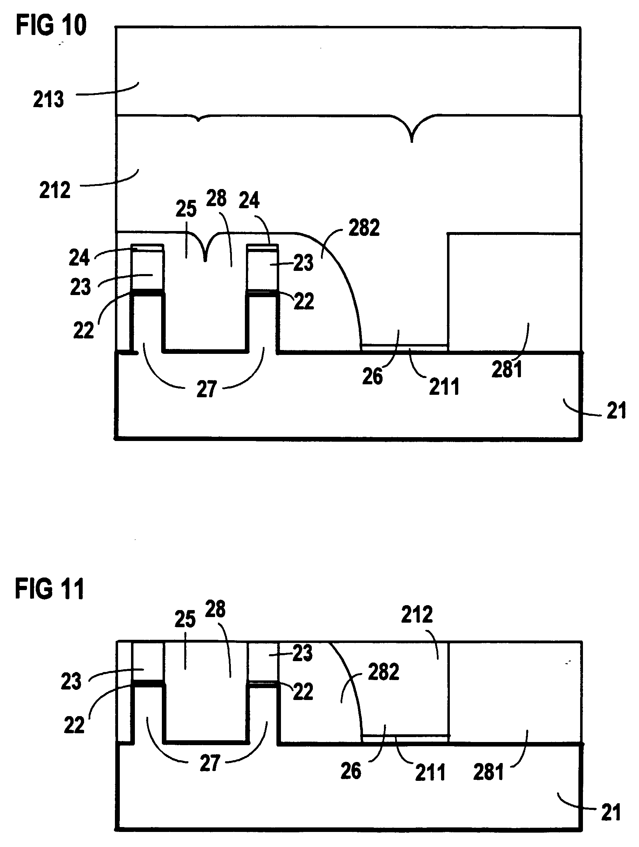

Anschließend wird eine thermische Oxidation durchgeführt, bei der an der freiliegenden Oberfläche des Substrats 21 im Bereich der zweiten isolierenden Gräben 26 eine SiO₂-Struktur 211 in einer Dicke von zum Beispiel 20 nm gebildet wird (siehe Figur 10).

Anschließend wird ganzflächig eine planarisierende SiO₂-Schicht 212 gebildet. Dazu wird ein fließfähiges SiO₂ abgeschieden und in einem Temperprozeß bei etwa 950 °C verflossen. Die planarisierende SiO₂-Schicht 212 wird zum Beispiel aus Silikatglas, zum Beispiel Borphosphorsilikatglas, Phosphorsilikatglas oder Borsilikatglas, oder aus einem fließfähigen Oxid, wie es zum Beispiel von der Firma Dow Corning unter dem Namen FOX™ vertrieben wird , gebildet. Auch nach dem Verfließen kann die planarsierende SiO₂-Schicht 212 in ihrer Oberfläche leichte Unebenheiten aufweisen.

Die planarisierende SiO₂-Schicht 212 wird in einer solchen Dicke gebildet, daß die zweiten isolierenden Gräben 26 oberhalb der SiO₂-Struktur 211 vollständig von der planarisierenden SiO₂-Schicht 212 aufgefüllt werden. Die planarisierende SiO₂-Schicht 212 wird zum Beispiel in einer Schichtdicke von 600 nm abgeschieden.

Anschließend wird ganzflächig eine planarisierende Lackschicht 213 gebildet, die die in der Oberfläche der planarisierenden SiO₂-Schicht verbliebenen Unebenheiten ausgleicht. Die planarisierende SiO₂-Schicht und die planarsierende Lackschicht 213 bilden gemeinsam eine zweite isolierende Schicht mit planarer Oberfläche. Die planarisierende Lackschicht 213 wird vorzugsweise aus einem Lack mit einer großen Planarisierungslänge im Bereich von bis zu 200 nm gebildet. Als planarisierender lack ist zum Beispiel der Lack Accuflo der Firma Allied Signal geeignet.

In einem anisotropen Trockenätzprozeß, der die planarisierende Lackschicht 213, die planarisierende SiO₂-Schicht 212 und die erste isolierende Schicht 28 mit gleicher Ätzrate angreift, zum Beispiel mit einem CHF₃/NF₃/Ar-Plasma wird anschließend ein planarisierender Schichtabtrag durchgeführt. Der Trockenätzprozeß wird solange fortgesetzt, bis die Oberfläche der ersten Elektrodenschicht 23 freigelegt ist (siehe Figur 11). Da die Oberfläche der ersten Elektrodenschicht 23 etwa 200 nm oberhalb des Gatedielektrikums 22 und der Oberfläche der aktiven Gebiete 27 angeordnet ist, sind hierbei Toleranzen im Bereich 150 - 170 nm tolerierbar. Es wird dabei sowohl in den ersten isolierenden Gräben 25 als auch in den zweiten isolierenden Gräben 26 eine isolierende Füllung mit planarer Oberfläche gebildet. In den zweiten isolierenden Gräben 26 umfaßt die isolierende Füllung unter anderem die Spacer 282, die Stützstrukturen 281, die durch Strukturierung der ersten isolierenden Schicht 28 entstanden sind, sowie die SiO₂-Schicht 211 und die planarisierende SiO₂-Schicht 212. In den ersten isolierenden Gräben 25 umfaßt die isolierende Füllung hauptsächlich Material der ersten isolierenden Schicht 28.

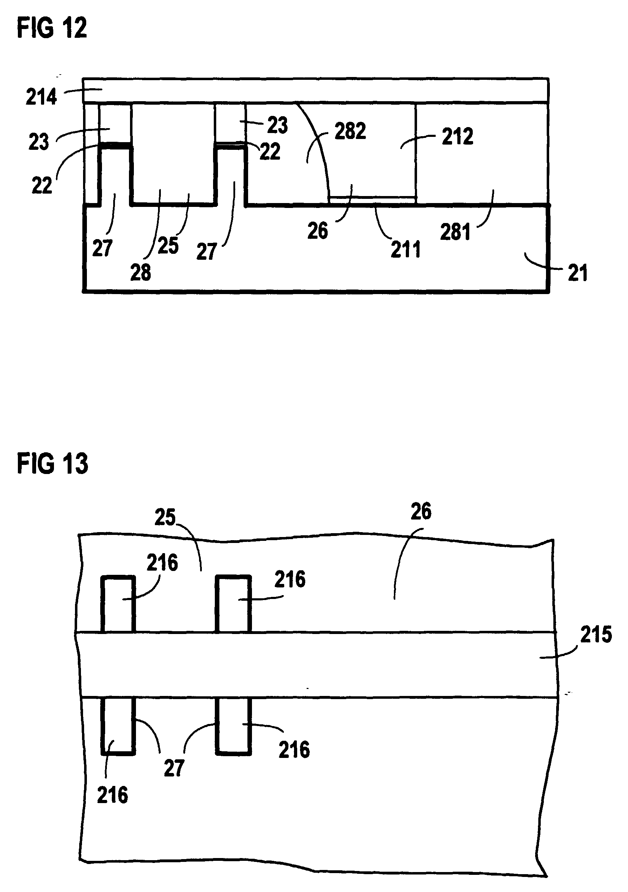

Anschließend wird ganzflächig eine zweite Elektrodenschicht 214 aufgebracht (siehe Figur 12). Die zweite Elektrodenschicht 214 wird aus leitfähigem Material, zum Beispiel aus Wolfram, dotiertem Polysilizium, einem anderen Metall, Metallsilizid, TiN oder aus einer Schichtkombination aus Metall und Silizium, TiN und Silizium oder einem dünnen Dielektrikum (SiO₂ oder Si₃N₄) und dotiertem Silizium gebildet.

Unter Verwendung einer gemeinsamen Maske und eines anisotropen Trockenätzprozesses werden anschließend die zweite Elektrodenschicht 214 und die strukturierte erste Elektrodenschicht 23 strukturiert. Dabei wird aus der zweiten Elektrodenschicht 214 eine Leitungsebene 215 gebildet (siehe Aufsicht in Figur 13). Unterhalb der Leitungsebene 215 entstehen aus der ersten Elektrodenschicht 23 Gateelektroden. Die Leitungsebene 215 verbindet dabei Gateelektroden, die in unterschiedlichen aktiven Gebieten 27 angeordnet sind.

Nachfolgend werden in bekannter Weise an den Flanken der Leitungsebene 215 und der Gateelektroden isolierende Spacer gebildet (nicht dargestellt). Durch Implantation werden in den aktiven Gebieten 27 Source/Drain-Gebiete 216 gebildet, die gemeinsam mit dem Gatedielektrikum 22 und der zugehörigen Gateelektrode MOS-Transistoren bilden.

Die integrierte Schaltung wird durch Abscheidung eines Zwischenoxids, Öffnen von Kontaktlöchern und Bildung von Metallisierungen in bekannter Weise fertiggestellt.

Sollen in der integrierten Schaltungsanordnung Gateelektroden unterschiedlicher Dotierung gebildet werden, zum Beispiel in einer CMOS-Schaltung in Dual-Gate-Technologie, so wird die erste Elektrodenschicht 23 vor der Abscheidung der zweiten Elektrodenschicht 214 und vorzugsweise nach der Strukturierung unter Verwendung einer oder mehrerer zusätzlicher Masken lokal dotiert.

## Patentansprüche

1. Verfahren zur Herstellung einer integrierten Schaltungsanordnung,
- bei dem in einer Hauptfläche (12) eines Halbleitersubstrats (11) erste isolierende Gräben (13) und zweite isolierende Gräben (14) geätzt werden, die aktive Gebiete (15) definieren,
- bei dem die ersten isolierenden Gräben (13) eine geringere Weite aufweisen als die zweiten isolierenden Gräben (14),
- bei dem eine erste isolierende Schicht (16) mit im wesentlichen konformer Kantenbedeckung gebildet wird, die die ersten isolierenden Gräben (13) im wesentlichen auffüllt,
- bei dem eine Maske (17) gebildet wird, die oberhalb der ersten isolierenden Gräben (13) und oberhalb der aktiven Gebiete (15) Öffnungen (18) aufweist, wobei die oberhalb der aktiven Gebiete (15) angeordneten Öffnungen (18) die aktiven Gebiete (15) seitlich überlappen,
- bei dem die erste isolierende Schicht (16) durch anisotropes Ätzen strukturiert wird, wobei oberhalb der zweiten isolierenden Graben (14) Stützstrukturen (161) und an den Flanken der zweiten Gräben Spacer (162) gebildet werden,
- bei dem die Maske (17) entfernt wird,
- bei dem eine zweite isolierende Schicht (120) mit im wesentlichen planarer Oberfläche gebildet wird,
- bei dem die Hauptfläche (12) im Bereich der aktiven Gebiete (15) durch einen planarisierenden Schichtabtrag freigelegt wird.

2. Verfahren nach Anspruch 1,
bei dem die Öffnungen (18) der Maske (17), die oberhalb der
aktiven Gebiete (15) angeordnet sind, die aktiven Gebiete (15) seitlich um einen Abstand überlappen, der mindestens so groß wie die Dicke der ersten isolierenden Schicht (16) ist.

3. Verfahren nach Anspruch 1 oder 2,
bei dem der planarisierende Schichtabtrag durch anisotropes Trockenätzen erfolgt.

4. Verfahren nach einem der Ansprüche 1 bis 3,
- bei dem auf der Hauptfläche des Halbleitersubstrats (21) vor der Ätzung der ersten isolierenden Gräben (25) und der zweiten isolierenden Gräben (26) ein Gatedielektrikum (22) und eine erste Elektrodenschicht (23) gebildet werden,
- bei dem das Gatedielektrikum (22) und die erste Elektrodenschicht (23) bei der Ätzung der ersten isolierenden Gräben (25) und der zweiten isolierenden Gräben (26) strukturiert werden,
- bei dem bei dem planarisierenden Schichtabtrag die Oberfläche der strukturierten ersten Elektrodenschicht (23) freigelegt wird.

5. Verfahren nach Anspruch 4,
bei dem nach der Ätzung der ersten isolierenden Gräben (25) und der zweiten isolierenden Gräben (26) eine thermische Oxidation durchgeführt wird.

6. Verfahren nach Anspruch 4 oder 5,
bei dem zur Bildung der zweiten isolierenden Schicht mindestens eine Schicht (212) aus verfließbarem Oxid abgeschieden und verflossen wird.

7. Verfahren nach einem der Ansprüche 4 bis 6,
- bei dem nach dem planarisierenden Schichtabtrag eine zweite Elektrodenschicht (214) gebildet wird,
- bei dem die zweite Elektrodenschicht (214) und die erste Elektrodenschicht (23) unter Verwendung einer gemeinsamen Maske strukturiert werden, wobei aus der ersten Elektrodenschicht (23) Gateelektroden und aus der zweiten Elektrodenschicht (214) eine Leitungsebene (215), die Gateleitungen zwischen Gateelektroden umfaßt, gebildet wird,
- bei dem Source/Drain-Gebiete (216) gebildet werden, die jeweils mit einer der Gateelektroden einen MOS-Transistor bilden.

8. Verfahren nach Anspruch 7,
- bei dem mindestens ein n-Kanal-MOS-Transistor und ein p-Kanal-MOS-Transistor gebildet werden, die unterschiedlich dotierte Gateelektroden aufweisen,
- bei dem zur unterschiedlichen Dotierung der Gateelektroden die strukturierte erste Elektrodenschicht (23) vor der Bildung der zweiten Elektrodenschicht (214) unterschiedlich dotiert wird.

9. Verfahren nach einem der Ansprüche 1 bis 8,
- bei dem die erste isolierende Schicht aus SiO₂ gebildet wird,
- bei dem die erste Elektrodenschicht (23) aus dotiertem Polysilizium gebildet wird,
- bei dem die zweite Elektrodenschicht (214) mindestens eines der Materialien dotiertes Silizium, Metallsilizid, Metall und/oder einen organischen Leiter enthält,
- bei dem das Halbleitersubstrat mindestens im Bereich der Hauptfläche monokristallines Silizium aufweist.
